# FASCICULE DE BREVET EUROPEEN

(11) **EP 0 561 692 B1**
(45) Date de publication et mention de la délivrance du brevet: **18.02.1998**
(21) Numéro de dépôt: 93400671.9
(22) Date de dépôt: 16.03.1993
(51) Int. Cl.: H04B 10/18, H01S 3/133

(54) **Procédé et système de télécommunication optique**
Verfahren und Anordnung zur optischen Nachrichtenübertragung
Optical telecommunication method and apparatus

(30) Priorité: 18.03.1992 FR 9203244
(43) Date de publication de la demande: 22.09.1993
(73) Titulaire: ALCATEL ALSTHOM COMPAGNIE GENERALE D'ELECTRICITE, 75008 Paris (FR)
(72) Inventeur: Biotteau, Bernard, F-91290 Arpajon (FR)
(74) Mandataire: Bourely, Paul

(56) Documents cités:
- EP-A- 0 504 834
- DE-A- 4 028 818
- US-A- 4 980 891
- PATENT ABSTRACTS OF JAPAN vol. 10, no. 283 (E-440)26 Septembre 1986 & JP-A-61 102 081

## Description

La présente invention concerne les télécommunications par fibres optiques, et plus particulièrement l'amélioration de la qualité de telles télécommunications dans le cas où des informations transmises sont portées sous forme numérique par une modulation de phase appliquée à une onde porteuse optique. L'onde porteuse et sa modulation peuvent être caractérisés par divers paramètres qui sont distincts de l'information à transmettre et qui influent sur la qualité de la transmission, c'est-à-dire sur le taux d'erreurs qui apparaît par comparaison de l'information appliquée à l'émission avec l'information restituée à la réception.

Pour donner à ces paramètres des valeurs optimales minimisant ce taux d'erreurs, il est connu de faire varier de tels paramètres, de surveiller les variations du taux d'erreur, et de choisir pour ces paramètres les valeurs qui font apparaître les taux d'erreurs les plus faibles.

Cette méthode de réglage de paramètre apparaît complexe et coûteuse lorsqu'un paramètre doit être réglé de manière périodique en raison d'une dérive naturelle d'un composant utilisé à l'émission.

Pour permettre un tel réglage d'une manière plus simple et économique, la présente invention utilise l'effet Brillouin. Cet effet sera décrit plus loin.

Selon un document D1 : EP-A-O 504 834, dans le cadre de la transmission d'une information par la modulation d'amplitude d'une onde guidée par une fibre optique, une rétrodiffraction parasite par effet Brillouin est généralement évitée en surajoutant une modulation de fréquence. Pour limiter des conséquences nuisibles que cette modulation de fréquence entraine par ailleurs, on limite ou abaisse son amplitude, ce qui peut faire apparaitre provisoirement cette rétrodiffraction parasite. Lorsqu'on détecte cette dernière on réagit en réaugmentant suffisamment l'amplitude de la modulation de fréquence pour faire disparaitre la rétrodiffraction parasite. Ce document a été publié le 23/09/92.

Selon un document D2 : Patent Abstract of Japan, vol 10 n° 283 relatif à la publication n° JP 61102081, la fréquence d'une onde d'excitation émise par un laser et injectée dans une fibre est asservie à l'aide de la surveillance d'une onde de fréquence connue qui s'est propagée en sens inverse dans cette fibre où elle a été amplifiée par un effet Brillouin.

Un document D3 : DE-1-4 028 818 concerne lui aussi la stabilisation de la fréquence d'un laser semiconducteur. Il utilise un laser en anneau constitué par une fibre optique dans laquelle deux ondes Brillouin circulent dans les deux sens.

La présente invention a notamment pour objet un procédé de télécommunication optique dans lequel une information à transmettre est portée par une modulation d'une onde porteuse injectée dans une fibre de ligne, ce procédé étant caractérisé par le fait qu'on définit des paramètres d'une onde de réglage tels qu'une injection de cette onde de réglage dans ladite fibre de ligne engendre une onde renvoyée par cette fibre par effet Brillouin, on forme une dite onde de réglage, on injecte cette onde de réglage dans ladite fibre de ligne, et on définit une valeur optimale d'un paramètre à régler de cette onde porteuse en fonction des variations de la puissance d'une dite onde renvoyée par effet Brillouin.

Cette invention a également pour objet un système de transmission utilisant ce procédé.

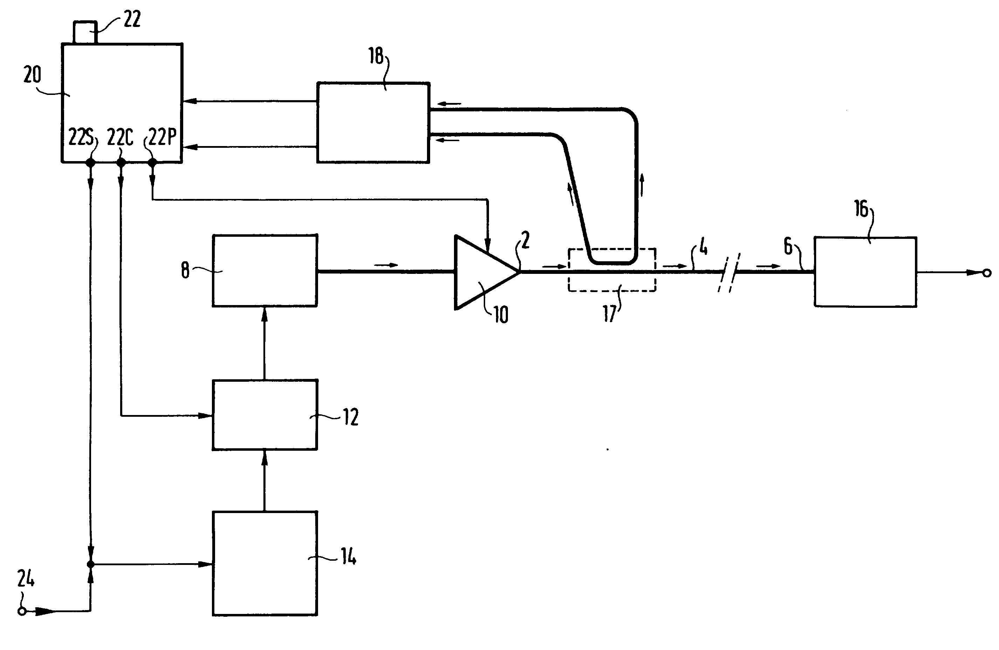

A l'aide de la figure schématique ci-jointe, on va décrire plus particulièrement ci-après, à titre d'exemple non limitatif, comment la présente invention peut être mise en oeuvre.

Cette figure représente un système de transmission d'information mettant le procédé de cette invention en oeuvre.

On va tout d'abord donner diverses indications relatives à l'effet Brillouin. C'est un effet qui peut être provoqué dans divers milieux transparents par une onde optique de forte intensité. Il peut apparaître dans les fibres optiques d'un système de télécommunication par suite de l'utilisation d'amplificateurs optiques. Ces amplificateurs permettent en effet d'augmenter considérablement la puissance des ondes injectées dans les fibres optiques. Des puissances moyennes de l'ordre de 20 dBm (100 mW) et plus sont possibles. Elles font apparaître dans les fibres des effets non linéaires qui perturbent notablement la transmission. L'un des effets les plus importants, car apparaissant à partir d'un seuil de puissance relativement faible, est l'effet Brillouin stimulé (SBS). Sa description a été effectuée de façon assez complète par COTTER. Il résulte de l'interaction de trois ondes : une onde optique incidente (la pompe) crée par électrostriction une onde de pression qui introduit une variation de la susceptibilité diélectrique du milieu, de sorte que cette onde de pression diffracte partiellement l'onde incidente en formant une onde diffractée par effet Stokes stimulé.

Les principales caractéristiques de l'effet Brillouin stimulé dans les fibres peuvent être définies en se référant à un "gain Brillouin" qui est le gain que la fibre optique applique à l'onde diffractée. Ces caractéristiques sont les suivantes :
- La largeur spectrale V_{B} du gain Brillouin est comprise entre 20 et 100 MHz pour des fibres optiques de silice monomodales. Elle est fonction de la géométrie de la fibre et de la nature des dopants.
- Ce gain est une fonction de la largeur spectrale V_{L} de l'onde incidente : pour des largeurs V_{L} non supérieures à V_{B} il est maximum et décroit dans le rapport V_{B}/V_{L} lorsque V_{L} est très supérieur à V_{B}.
- L'onde diffractée est renvoyée dans le sens opposé à celui de l'onde incidente. Sa fréquence est inférieure à celle de l'onde incidente d'une quantité f_{B} = 2n Vₛ/Lp avec
   - n =: indice de réfraction
   - Vₛ =: vitesse du son dans la silice,
   - Lp =: longueur d'onde de l'onde incidente.

Pour les fibres monomodes utilisées pour des liaisons à longues distances, f_{B} est voisin de 11 GHz.
- Enfin le gain Brillouin est sensible à la modulation de l'onde incidente du fait de l'incidence directe de la modulation sur le spectre de cette onde.

Il est d'autant plus faible que la largeur spectrale due à la modulation est grande devant la largeur spectrale du gain. Il dépend du format de modulation utilisé (modulation de phase, de fréquence ou d'amplitude). Dans le cas d'une modulation de phase, LICHTMAN a montré que le gain Brillouin dépendait de divers paramètres de cette modulation. La largeur spectrale de la séquence de modulation est l'un des ces paramètres. Elle est fonction du débit d'information porté par cette séquence et elle constitue un "paramètre de séquence" considéré ci-après.

AOKI a montré que le gain Brillouin est aussi fonction du type de codage utilisé pour la modulation.

Un seuil Brillouin est défini comme la puissance moyenne d'onde incidente à partir de laquelle une onde est diffractée par effet Brillouin. Il est inversement proportionnel au gain Brillouin.

Référence est faite aux documents suivants :
COTTER : Stimulated Brillouin Scattering in monomod Optical Fier (Jl of Optical Communications 4, (1983)1, 10-19.
LICHTMAN : Stimulated Brillouin Scattering Excited by a Modulated Pump Wave in Single Mode Fibers (Jl of light wave Technology vol 7, n°1, January 1989).
AOKI : Imput power limit of Single Mode Optical Fibers due to Stimulated Brillouin Scattering in Optical Communication Systems. (Jl of lightwave Technology vol 6 n°5, mai 1988).

Un procédé de transmission selon la présente invention comporte les opérations connues suivantes :
- On injecte dans une entrée 2 de la fibre de ligne 4 une onde incidente présentant une modulation portant un signal d'entrée. Cette onde incidente avec sa modulation est définie par les valeurs de paramètres d'émission et par un signal d'entrée porté par cette modulation. Ces valeurs de paramètres se conservent. Au moins deux de ces paramètres d'émission constituent des paramètres réglables dont les valeurs peuvent être réglées. Au moins un paramètre réglable constitue un paramètre à régler dont la valeur doit être définie et réglée à des temps successifs. Un exemple d'un tel paramètre sera donné plus loin.
- On définit une valeur optimale de chacun desdits paramètres réglables.
- On fait porter une information à transmettre par ledit signal d'entrée. Chacun des paramètres réglables est réglé pour cela aussi près que possible de sa valeur optimale. Le signal d'entrée et l'onde incidente constituent alors respectivement un signal informatif et une onde porteuse.
- On reçoit l'onde porteuse à une sortie 6 de la fibre de ligne 4,
- et on traite l'onde porteuse reçue pour restituer l'information à transmettre.

L'information restituée à partir de cette onde porteuse reçue présente en général un taux d'erreurs. Les valeurs optimales des paramètres réglables sont celles qui rendent ce taux d'erreur minimal sauf en ce qui concerne la largeur de bande d'un signal informatif, la largeur optimale étant celle qui est définie par le débit d'information à transmettre.

Selon la présente invention la valeur optimale du paramètre à régler est définie par les opérations suivantes :
- On injecte dans la fibre de ligne 4 une onde incidente constituant une onde de réglage.
- On choisit un paramètre d'exploration constitué par un dit paramètre réglable de cette onde de réglage autre que le paramètre à régler.
- On donne à ce paramètre d'exploration des valeurs diverses dont certaines au moins sont choisies différentes de sa valeur optimale pour que la fibre de ligne présente un effet Brillouin qui lui fait renvoyer en arrière une onde diffractée. La puissance de cette onde constitue une puissance renvoyée.
- On détecte des variations de cette puissance renvoyée.
- Et on définit la valeur optimale du paramètre à régler à partir des variations ainsi détectées de cette puissance renvoyée.

Un système de transmission mettant ce procédé en oeuvre comporte les éléments suivants :
- Une source laser constituée par un émetteur 8 semiconducteur et un amplificateur 10. Cette source émet une onde incidente lorsqu'elle reçoit un courant d'alimentation, et la fréquence de cette onde est commandée par un courant de modulation de part et d'autre d'une fréquence moyenne prédéterminée.
- Un générateur d'impulsions de modulation 12 fournit ledit courant de modulation sous la forme d'impulsions de modulation successives et de préférence alternées.

Ces impulsions ont un calibre constitué par l'intégrale de leur intensité sur leur durée. Ce calibre constitue ledit paramètre à régler.

Ce générateur permet de régler la valeur de ce calibre pour la rendre égale à une valeur optimale provoquant une excursion de phase optimale de ladite onde porteuse. Cette excursion de phase optimale est de préférence égale à 180 degrés.
- Un générateur de séquence 14 recevant le signal d'entrée et commandant le générateur d'impulsions 12 pour que ce dernier réalise une séquence de modulation représentative de ce signal d'entrée. Une telle séquence de modulation est réalisée par le fait que le générateur d'impulsions fournit les impulsions de modulation à des instants définis par cette séquence de modulation. Un paramètre de ce signal d'entrée est dépourvu de valeur informative. Il est réglable et constitue un paramètre de séquence. Il peut être constitué par une largeur spectrale de ce signal.
- La fibre de ligne 4. Cette fibre est naturellement apte à renvoyer vers la source 8, 10 une dite onde diffractée dont l'énergie est prélevée sur celle de l'onde incidente, ceci par stimulation selon l'effet Brillouin. Cette onde diffractée est formée et renvoyée lorsque une puissance incidente, qui est celle de cette onde incidente, dépasse le seuil Brillouin. Ce seuil dépend des valeurs des paramètres réglables.
- Un récepteur 16 qui reçoit et détecte l'onde porteuse pour restituer l'information à transmettre.

Cette détection peut être hétérodyne ou directe. Dans ce dernier cas la modulation de phase est transformée en modulation d'intensité.
- Un coupleur optique 17 pour recueillir des fractions predéterminées de l'onde incidente et de l'onde diffractée qui circulent dans la fibre 4.
- Un organe de mesure 18 pour mesurer les puissances de ces fractions, donc les puissances incidente et renvoyée.
- Et un organe de réglage automatique 20 recevant les mesures de ces puissances incidente et renvoyée. Cet organe peut être déclenché soit manuellement par un bouton 22 soit automatiquement, soit quand le besoin d'un nouveau réglage du calibre apparaît, soit à intervalles de temps predéterminés.

Il présente trois sorties. Un sortie 22P commande la puissance incidente fournie par l'amplificateur 10. Un sortie 22C modifie l'intensité des impulsions fournies par le générateur d'impulsions 12, de manière à assurer ainsi le réglage du calibre de modulation, la durée et le type de profil de variation de ces impulsions étant prédéterminés. Une sortie 22S commande le paramètre de séquence. Pour cela elle fournit un signal d'aide au réglage qui est dépourvu de valeur informative et qui est transmis au générateur de séquence 14 pour constituer le signal d'entrée pendant une opération de réglage.

En dehors des opérations de réglage, pendant des périodes de transmission d'information, le signal d'entrée est constitué par un signal informatif appliqué à une entrée 24 du système.

Pendant les opérations de réglage la puissance incidente constitue un dit paramètre d'exploration, c'est-à-dire que, sous la commande de l'organe de réglage 20, l'amplificateur 10 fait varier la puissance incidente entre une valeur maximale autorisée par la source 8, 10 et une valeur minimale, pour provoquer des variations de la puissance renvoyée. Grâce aux mesures de cette puissance incidente et de cette puissance renvoyée, l'organe de réglage 20 détermine le seuil Brillouin de la fibre 4. Il fait alors varier le calibre des impulsions de modulation pour maximiser le seuil Brillouin ainsi mesuré.

De préférence le paramètre de séquence constitue un dit paramètre d'exploration qui est utilisé comme suit : Avant de faire varier la puissance incidente, l'organe de réglage 20 donne au paramètre de séquence une valeur choisie pour que la séquence de modulation constitue une séquence d'aide au réglage donnant au seuil Brillouin une valeur inférieure à la fois à ladite valeur maximale de la puissance incidente et à la valeur qui est donnée au seuil Brilllouin par ladite valeur optimale de ce paramètre de séquence. De telles séquences d'aide au réglage sont des séquences dites fixes présentant une largeur spectrale relativement faible.

Pendant les périodes de transmission d'information le signal informatif donne à ce paramètre de séquence sa valeur optimale. Ceci permet d'utiliser la source 8, 10 au voisinage du maximum de sa puissance sans risquer de provoquer l'apparition d'une onde diffractée perturbatrice pendant la transmission d'informations.

Dans le mode de réalisation décrit ci-dessus les opérations de réglage excluent temporairement les opérations de transmission d'information. Toutes ces opérations de transmission sont alors optimisées en ce sens qu'on donne à chaque paramètre réglable sa valeur optimale. Il doit cependant être compris qu'une dite onde de réglage peut constituer en même temps une dite onde porteuse d'information au cours d'opérations de transmission non optimisées constituant en même temps des opérations de réglage.

Le procédé selon l'invention s'applique avec avantage à un système de transmission à modulation de phase dont on veut optimiser le déphasage à 180 degrés (ou(2k+1) x 180 degrés). Il permet alors une régulation des caractéristiques de sensibilité de la fréquence au courant de modulation de l'émetteur 8. Il s'applique cependant aussi avec avantage à un système de transmission à modulation d'amplitude.

La mesure de la puissance incidente peut être utile pour contrôler les caractéristiques en puissance de la source.

En ce qui concerne la mesure de la puissance renvoyée, on peut tenir compte de la puissance qui est rétrodiffusée par un autre effet connu sous le nom d'effet Rayleigh et qui s'ajoute à la puissance renvoyée par effet Brillouin. Cette puissance rétrodiffusée est généralement négligeable, et peut être connue grâce à la mesure de la puissance incidente.

## Revendications

1. Procédé de télécommunication optique dans lequel une information à transmettre est portée par une modulation d'une onde porteuse injectée dans une fibre de ligne (4), ce procédé étant caractérisé par le fait qu'on définit des paramètres d'une onde de réglage tels qu'une injection de cette onde de réglage dans ladite fibre de ligne engendre une onde renvoyée par cette fibre par effet Brillouin, on forme une dite onde de réglage, on injecte cette onde de réglage dans ladite fibre de ligne, et on définit une valeur optimale d'un paramètre à régler de cette onde porteuse en fonction des variations de la puissance d'une dite onde renvoyée par effet Brillouin.

2. Procédé de transmission optique selon la revendication 1, ce procédé comportant des opérations dans lesquelles on injecte dans une entrée (2) de ladite fibre de ligne (4) une onde incidente présentant une modulation portant un signal d'entrée, cette onde incidente avec sa modulation étant définie par les valeurs de paramètres d'émission et par ledit signal d'entrée, lesdites valeurs de ces paramètres se conservant, au moins deux dits paramètres d'émission constituant des paramètres réglables dont les valeurs peuvent être réglées, au moins un dit paramètre réglable constituant un paramètre à régler dont la valeur doit être réglée,
certaines au moins desdites opérations constituant des opérations de transmission dans lesquelles :
- on fait porter une information à transmettre par ledit signal d'entrée, ledit signal d'entrée et ladite onde incidente constituant alors respectivement un signal informatif et une onde porteuse,
- on reçoit ladite onde porteuse à une sortie (6) de ladite fibre de ligne (4),
- et on traite ladite onde porteuse à ladite sortie de la fibre de ligne pour restituer ladite information à transmettre, l'information restituée à partir de cette onde porteuse pouvant présenter un taux d'erreur, ce taux d'erreurs étant minimal lorsque chacun desdits paramètres réglables de ladite onde porteuse est réglé à une valeur optimale de ce paramètre, lesdites valeurs optimales desdits paramètres réglables autres qu'un dit paramètre à régler étant des valeurs optimales prédéterminées,
ledit procédé étant caractérisé par le fait que certaines desdites opérations constituent des opérations de réglage dans lesquelles :
- on injecte dans ladite fibre de ligne (4) une dite onde incidente constituant une onde de réglage,
- on choisit un paramètre d'exploration constitué par un dit paramètre réglable de ladite onde de réglage autre que ledit paramètre à régler,
- au donne audit paramètre d'exploration des valeurs diverses dont certaines au moins sont choisies différentes de sa dite valeur optimale pour que ladite fibre de ligne présente un effet Brillouin qui lui fait renvoyer en arrière une onde diffractée dont la puissance constitue une puissance renvoyée,
- on détecte des variations de ladite puissance renvoyée,
- et on définit ladite valeur optimale dudit paramètre à régler à partir desdites variations détectées de ladite puissance renvoyée.
- certaines au moins desdites opérations de transmission étant des opérations de transmission optimisées dans lesquelles on donne audit paramètre à régler de ladite onde porteuse sa dite valeur optimale définie par lesdites opérations de réglage, et on donne à chaque autre dit paramètre réglable sa dite valeur optimale prédéterminée.

3. Procédé selon la revendication 2, la fréquence de ladite onde incidente étant commandée au voisinage d'une fréquence prédéterminée par un courant de modulation présentant la forme d'impulsions de modulation successives, ces impulsions ayant un calibre constitué par l'intégrale de leur intensité sur leur durée et constituant ledit paramètre à régler, ce calibre pouvant prendre une valeur optimale provoquant une excursion de phase optimale de ladite onde porteuse, les dites impulsions de modulation étant fournies à des instants définis par une séquence de modulation représentative dudit signal d'entrée, un paramètre de ce signal d'entrée étant dépourvu de valeur informative et constituant un paramètre de séquence, ladite onde diffractée étant formée et renvoyée lorsqu'une puissance incidente, qui est celle de ladite onde incidente, dépasse un seuil Brillouin dépendant desdits paramètres réglables.

4. Procédé selon la revendication 3 caractérisé par le fait que ladite valeur optimale du calibre de modulation est définie comme celle qui donne une valeur maximale audit seuil Brillouin, grâce à quoi cette valeur optimale de ce calibre provoque une dite excursion de phase optimale égale à 180 degrés.

5. Procédé selon la revendication 4 caractérisé par le fait que ladite puissance incidente constitue un dit paramètre d'exploration, ce procédé comportant les opérations suivantes :
- lorsqu'on injecte ladite onde de réglage dans ladite fibre de ligne (4), on fait varier ladite puissance incidente entre une valeur maximale autorisée par ladite source (8, 10) et une valeur minimale pour provoquer des variations de ladite puissance renvoyée,
- on mesure cette puissance incidente et cette puissance renvoyée pour déterminer ledit seuil Brillouin,
- et on règle ledit calibre pour maximiser le seuil Brillouin ainsi déterminé.

6. Procédé selon la revendication 5 caractérisé par le fait que ledit paramètre de séquence constitue un dit paramètre d'exploration, et que, avant ladite opération où on fait varier ladite puissance incidente, on donne audit paramètre de séquence une valeur choisie pour que ladite séquence de modulation constitue une séquence d'aide au réglage donnant audit seuil Brillouin une valeur inférieure à la fois à ladite valeur maximale de la puissance incidente et à la valeur qui est donnée audit seuil Brillouin par ladite valeur optimale de ce paramètre de séquence.

7. Procédé selon la revendication 3, dans lequel lesdites impulsions de modulation ont une durée et un type de profil de variation predeterminés, ledit paramètre à régler étant représenté par une intensité réglable de ces impulsions.

8. Système de transmission comportant :
- une source laser à semi-conducteur (8-10) apte à émettre une onde optique constituant une onde incidente, la fréquence de cette onde incidente étant commandée par un courant de modulation au voisinage d'une fréquence prédéterminée, de manière à faire porter un signal d'entrée par une modulation de fréquence de cette onde incidente,
- un générateur d'impulsions de modulation (12) pour fournir ledit courant de modulation sous la forme d'impulsions de modulation successives, ces impulsions ayant un calibre constitué par l'intégrale de leur intensité sur leur durée, ce calibre étant réglable,
- un générateur de séquence (14) recevant ledit signal d'entrée et commandant ledit générateur d'impulsions (12) pour que ce demier réalise une séquence de modulation représentative de ce signal d'entrée, cette séquence de modulation étant réalisée par le fait que ledit générateur d'impulsions fournit lesdites impulsions de modulation à des instants définis par cette séquence de modulation, un paramètre de ce signal d'entrée étant dépourvu de valeur informative et constituant un paramètre de séquence,
- une fibre de ligne (4) recevant et guidant ladite onde incidente, cette fibre de ligne étant apte à renvoyer vers ladite source (8,10) une onde diffractée dont l'énergie est prélevée sur celle de ladite onde incidente par stimulation selon l'effet Brillouin, cette onde diffractée étant formée et renvoyée lorsque la puissance de cette onde incidente dépasse un seuil Brillouin dépendant de paramètres réglables incluant ledit calibre et ledit paramètre de séquence, la puissance de cette onde diffractée constituant une puissance renvoyée,
- un récepteur (16) recevant ladite onde incidente en sortie de ladite fibre de ligne pour restituer une information à transmettre qui était éventuellement portée par ledit signal d'entrée,
- un organe de mesure (18) pour mesurer ladite puissance renvoyée, et
- un organe de réglage (20),
cet organe de réglage commandant :
- ladite source laser (8, 10) en ce qui concerne la puissance de ladite onde incidente,
- ledit générateur d'impulsions (12) en ce qui conceme ledit calibre, et -ledit générateur de séquence (14) en ce qui conceme ledit paramètre de séquence,
cet organe de réglage étant connecté audit organe de mesure (18) pour être informé des valeurs de ladite puissance renvoyée, cet organe de réglage commandant lesdits générateurs et source de manière à réaliser des opérations de réglage pendant des périodes de réglage et à réaliser des opérations de transmission pendant des périodes de transmission extérieures à ces périodes de réglage, cet organe réalisant ces opérations de réglage en donnant des valeurs diverses à ladite puissance de l'onde incidente de manière à donner des valeurs diverses à ladite puissance renvoyée et en définissant une valeur optimale dudit calibre en fonction de ces valeurs diverses de la puissance renvoyée, cet organe réalisant ces opérations de transmission en faisant porter par ledit signal d'entrée une dite information à transmettre tout en donnant audit calibre sa dite valeur optimale et à ladite puissance de l'onde incidente une valeur prédéterminée.

## Patentansprüche

1. Verfahren zur optischen Nachrichtenübertragung, bei dem eine zu übertragende Information durch eine Modulation einer in eine Leitungsfaser (4) eingespeisten Trägerwelle befördert wird, dadurch gekennzeichnet, daß man Parameter einer Regelungswelle so festlegt, daß eine Einspeisung dieser Regelungswelle in die Leitungsfaser eine von dieser Faser durch Brillouin-Effekt zurückgeworfene Welle ergibt, man eine solche Regelungswelle erzeugt, diese Regelungswelle in die Leitungsfaser einspeist und einen optimalen Wert eines zu regelnden Parameters dieser Trägerwelle in Funktion der Leistungsänderungen einer solchen durch Brillouin-Effekt zurückgeworfenen Welle festlegt.

2. Verfahren zur optischen Nachrichtenübertragung nach Anspruch 1, welches Operationen umfaßt, bei denen man in einen Eingang (2) der Leitungsfaser (4) eine einfallende Welle einspeist, die eine Modulation aufweist, welche ein Eingangssignal befördert, wobei diese einfallende Welle mit ihrer Modulation durch die Werte von Sendeparametern und durch das Eingangssignal festgelegt ist, die Werte dieser Parameter erhalten bleiben, wenigstens zwei dieser Sendeparameter regelbare Parameter darstellen, deren Werte geregelt werden können, und wenigstens ein regelbarer Parameter einen zu regelnden Parameter darstellt, dessen Wert geregelt werden muß, wobei wenigstens bestimmte dieser Operationen Übertragungsoperationen darstellen, bei denen:
- man das Eingangssignal eine Information übertragen läßt, wobei das Eingangssignal und die einfallende Welle ein Informationssignal bzw. eine Trägerwelle darstellen,
- man die Trägerwelle an einem Ausgang (6) der Leitungsfaser (4) empfängt,
- und die Trägerwelle am Ausgang der Leitungsfaser verarbeitet, um die zu übertragende Information wiederherzustellen, wobei die aus dieser Trägerwelle wiederhergestellte Information eine Fehlerquote aufweisen kann, diese Fehlerquote minimal ist, wenn jeder der regelbaren Parameter der Trägerwelle auf einen optimalen Wert dieses Parameters geregelt ist, die optimalen Werte der regelbaren Parameter mit Ausnahme eines zu regelnden Parameters vorgegebene optimale Werte sind, dadurch gekennzeichnet, daß bestimmte der Operationen Regelungsoperationen darstellen, bei denen:
- man in die Leitungsfaser eine sogenannte einfallende Welle einspeist, die eine Regelungswelle darstellt,
- man einen Untersuchungsparameter wählt, dargestellt durch einen anderen regelbaren Parameter der Regelungswelle als den zu regelnden Parameter,
- man dem Untersuchungsparameter unterschiedliche Werte gibt, von denen wenigstens bestimmte abweichend von seinem optimalen Wert gewählt sind, damit die Faser einen Brillouin-Effekt zeigt, der sie eine gebrochene Welle zurückwerfen läßt, deren Leistung eine zurückgeworfene Leistung darstellt,
- man die Veränderungen dieser zurückgeworfenen Leistung erfaßt,
- und man den optimalen Wert des zu regelnden Parameters anhand der so erfaßten Änderungen der zurückgeworfenen Leistung festlegt,
- wobei wenigstens bestimmte der Übertragungsoperationen optimierte Übertragungsoperationen sind, bei denen man dem zu regelnden Parameter der Trägerwelle seinen durch die Regelungsoperationen festgelegten optimalen Wert gibt und jedem anderen regelbaren Parameter seinen vorgegebenen optimalen Wert gibt.

3. Verfahren nach Anspruch 2, bei dem die Frequenz der einfallenden Welle in der Nähe einer vorgegebenen Frequenz durch einen Modulationsstrom gesteuert wird, der die Form von aufeinanderfolgenden Modulationspulsen hat, wobei diese Pulse eine Stärke, gegeben durch das Integral ihrer Intensität über ihre Dauer, haben, die den zu regelnden Parameter darstellt und die einen optimalen Wert annehmen kann, der eine optimale Phasenabweichung der Trägerwelle hervorruft, wobei die Modulationsimpulse zu Zeitpunkten erzeugt werden, die durch eine Modulationssequenz festgelegt sind, die für das Eingangssignal repräsentativ ist, wobei ein Parameter dieses Eingangssignals keinen Informationsgehalt hat und einen Sequenzparameter darstellt; die gebrochene Welle gebildet und zurückgeworfen wird, wenn eine einfallende Leistung, die diejenige der einfallenden Welle ist, eine von den regelbaren Parametern abhängige Brillouin-Schwelle überschreitet.

4. Verfahren nach Anspruch 3, dadurch gekennzeichnet, daß der optimale Wert der Stärke der Modulation festgelegt ist als derjenige, der der Brillouin-Schwelle einen maximalen Wert gibt, so daß dieser optimale Wert der Stärke die optimale Phasenabweichung von 180° hervorruft.

5. Verfahren nach Anspruch 4, dadurch gekennzeichnet, daß die einfallende Leistung einen sogenannten Untersuchungsparameter darstellt, wobei das Verfahre folgende Schritte umfaßt:
- wenn man die Regelungswelle in die Leitungsfaser (4) einspeist, verändert man die einfallende Leistung zwischen einem maximalen für die Quelle (8, 10) zugelassenen Wert und einem minimalen Wert, um Veränderungen der zurückgeworfenen Leistung hervorzurufen,
- man mißt die einfallende Leistung und die zurückgeworfene Leistung , um die Brillouin-Schwelle zu bestimmen,
- und man regelt die Stärke, um die so bestimmte Brillouin-Schwelle zu maximieren.

6. Verfahren nach Anspruch 5, dadurch gekennzeichnet, daß der Sequenzparameter einen Untersuchungsparameter darstellt, und daß man vor der Operation, in der man die einfallende Leistung verändert, dem Sequenzparameter einen Wert gibt, der gewählt ist, damit die Modulationssequenz eine Regelungshilfssequenz darstellt, die der Brillouin-Schwelle einen Wert gibt, der niedriger als sowohl der Maximalwert der einfallenden Leistung als auch als der Wert ist, der der Brillouinschwelle durch den optimalen Wert des Sequenzparameters gegeben wird.

7. Verfahren nach Anspruch 3, bei dem die Modulationspulse eine vorgegebene Dauer und eine vorgegebene Art von Veränderungsprofil haben, wobei der zu regelnde Parameter durch eine regelbare Intensität dieser Pulse dargestellt ist.

8. Übertragungssystem mit:
- einer Halbleiterlaserquelle (8, 10), die in der Lage ist, eine optische Welle auszusenden, die eine einfallende Welle darstellt, wobei die Frequenz dieser einfallenden Welle durch einen Modulationsstrom in der Nähe einer vorgegebenen Frequenz gesteuert ist, um ein Eingangssignal durch eine Frequenzmodulation dieser einfallenden Welle befördern zu lassen,
- einem Modulationspulsgenerator (12) zum Erzeugen des Modulationsstroms in Form von aufeinanderfolgenden Modulationspulsen, wobei die Pulse eine Stärke haben, die durch das Integral ihrer Intensität über ihre Dauer gegeben ist, und diese Stärke regelbar ist,
- einem Sequenzgenerator (14), der das Eingangssignal empfängt und den Pulsgenerator (12) steuert, so daß letzterer eine Modulationssequenz erzeugt, die für das Eingangssignal repräsentativ ist, wobei die Modulationssequenz dadurch erzeugt wird, daß der Pulsgenerator die Modulationspulse zu Zeitpunkten erzeugt, die durch die Modulationssequenz festgelegt sind, wobei ein Parameter dieses Eingangssignals keinen Informationsgehalt hat und einen Sequenzparameter darstellt,
- einer Leitungsfaser (4), die die einfallende Welle empfängt und führt, wobei die Leitungsfaser in der Lage ist, zur Quelle (8, 10) eine gebrochene Welle zurückzuwerfen, deren Energie der einfallenden Welle durch Stimulation durch Brillouin-Effekt entzogen wird, wobei die gebrochene Welle gebildet und zurückgeworfen wird, wenn die Leistung der einfallenden Welle eine Brillouin-Schwelle überschreitet, die von regelbaren Parametern, darunter die Stärke und der Sequenzparameter, abhängt, und die Leistung der gebrochenen Welle eine zurückgeworfene Leistung darstellt,
- einem Empfänger (16), der die einfallende Welle am Ausgang der Leitungsfaser empfängt, um eine zu übertragende Information wiederherzustellen, die ggf. von dem Eingangssignal befördert wurde,
- einem Meßelement (18) zum Messen der zurückgeworfenen Leistung und
- einem Regelungselement (20) wobei das Regelungselement steuert:
- die Laserquelle (8, 10) betreffend die Leistung der einfallenden Welle,
- den Pulsgenerator (12) betreffend die Stärke und
- den Sequenzgenerator (14) betreffend den Sequenzparameter, wobei das Regelungselement ferner an das Meßelement (18) angeschlossen ist, um über die Werte der zurückgeworfenen Leistung informiert zu sein, und das Regelungselement die Generatoren und die Quelle steuert, um Regelungsoperationen im Laufe von Regelungszeiträumen und Übertragungsoperationen im Laufe von Übertragungszeiträumen außerhalb dieser Regelungszeiträume durchzuführen, wobei das Regelungselement diese Regelungsoperationen durchführt, indem es der Leistung der einfallenden Welle unterschiedliche Werte gibt, um der zurückgeworfenen Leistung unterschiedliche Werte zu geben, und einen optimalen Wert der Stärke in Funktion dieser verschiedenen Werte der zurückgeworfenen Leistung festlegt, wobei dieses Element die Übertragungsoperationen durchführt, indem es die Übertragungsoperationen durchführt, indem es das Eingangssignal eine solche zu übertragende Information befördern läßt und dabei der Stärke ihren optimalen Wert und der Leistung der einfallenden Welle einen vorgegebenen Wert gibt.

## Claims

1. An optical telecommunications method in which data to be transmitted is carried by modulating a carrier wave which is injected into a line fiber (4), said method being characterized by the fact that parameters of an adjustment wave are defined such that injecting the adjustment wave into said line fiber generates a returned wave that is returned via said fiber by Brillouin scattering, one of said adjustment waves is formed, and an optimum value for a parameter to be adjusted of the carrier wave is defined as a function of the variations in the power of one of said returned waves that is returned by Brillouin scattering.

2. An optical transmission method according to claim 1, including steps, in which an incident wave presenting modulation carrying an input signal is injected into an input (2) of said line fiber (4), the incident wave and its modulation being defined by the values of transmission parameters and by said input signal, said values of the parameters remaining constant, at least two of said transmission parameters constituting adjustable parameters for which the values can be adjusted, and at least one of said adjustable parameters constituting a parameter to be adjusted for which the value must be adjusted;
at least some of said steps constituting transmission steps in which:
said input signal is made to carry data to be transmitted, said input signal and said incident wave then respectively constituting a data signal and a carrier wave;
said carrier wave is received at an output (6) of said line fiber (4); and
the carrier wave is processed at said output of the line fiber to recover said data to be transmitted, the data recovered from the carrier wave possibly having an error rate, the error rate being minimal when each of said adjustable parameters of said carrier wave is adjusted to the optimum value for the parameter, said optimum values for said adjustable parameters other than one of said parameters to be adjusted being predetermined optimum values;
said method being characterized by the fact that some of said steps constitute adjustment steps, in which:
one of said incident waves constituting an adjustment wave is injected into said line fiber (4);
a scanning parameter is chosen constituted by one of said adjustable parameters of said adjustment wave other than said parameter to be adjusted;
said scanning parameter is given various values, at least some of which are chosen to be different from its optimum value so that said line fiber presents Brillouin scattering which returns a diffracted wave whose power constitutes returned power;
variations in said returned power are detected; and
said optimum value for said parameter to be adjusted is defined on the basis of the detected variations in said returned power;
at least some of said transmission steps being optimized transmission steps in which said parameter to be adjusted of said carrier wave is given its optimum value defined by said adjustment steps, and each of the other ones of said adjustable parameters is given its predetermined optimum value.

3. A method according to claim 2, deviation of the frequency of said incident wave being controlled in the vicinity of a predetermined frequency by a modulation current in the form of successive modulation pulses, pulse size being constituted by the integral of pulse current over pulse duration, and constituting said parameter to be adjusted, the size being able to take an optimum value causing optimum phase deviation of said carrier wave, said modulation pulses being supplied at instants defined by a modulating sequence representative of said input signal, a parameter of the input signal being free from data value and constituting a sequence parameter, and said diffracted wave being formed and returned when incident power which is the power of the incident wave exceeds a Brillouin threshold dependent on said adjustable parameters.

4. A method according to claim 3, characterized by the fact that said optimum value of the modulation size is defined as the value which gives a maximum value to said Brillouin threshold, whereby said optimum value of the size causes optimum phase deviation equal to 180 degrees.

5. A method according to claim 4, characterized by the fact that said incident power constitutes one of said scanning parameters, the method including the following steps:
when said adjustment wave is injected into said line fiber (4), said incident power is made to vary between a maximum value allowed by said source (8, 10) and a minimum value, to cause variations in said returned power;
the incident power and the returned power are measured to determine said Brillouin threshold; and
said size is adjusted to maximize the Brillouin threshold determined in this way.

6. A method according to claim 5, characterized by the facts that said sequence parameter constitutes a scanning parameter, and that, before said step during which said incident power is caused to vary, said sequence parameter is given a value chosen so that said modulating sequence constitutes an adjustment assistance sequence giving said Brillouin threshold a value less than said maximum value for the incident power and less than the value which is given to said Brillouin threshold by said optimum value for the sequence parameter.

7. A method according to claim 3, in which method said modulation pulses have a predetermined duration and a predetermined variation profile type, said parameter to be adjusted being represented by an adjustable current for the pulses.

8. A transmission system including:
a semiconductor laser source (8-10) capable of transmitting an optical wave constituting an incident wave, a modulation current controlling deviation of the frequency of the incident wave in the vicinity of a predetermined frequency, so as to make frequency modulation of the incident wave carry an input signal;
a modulation pulse generator (12) for supplying said modulation current in the form of successive modulation pulses, pulse size being constituted by the integral of pulse current over pulse duration, the size being adjustable;
a sequence generator (14) receiving said input signal and controlling said pulse generator (12) so that the pulse generator delivers a modulating sequence representative of the input signal, the modulating sequence being obtained by the said pulse generator supplying said modulation pulses at instants defined by the modulating sequence, a parameter of the input signal being free from data value and constituting a sequence parameter;
said line fiber (4) receiving and guiding said incident wave, the line fiber being capable of returning a diffracted wave to said source (8, 10), the energy of which diffracted wave is taken from the energy of said incident wave by stimulated Brillouin scattering, the diffracted wave being formed and returned when the power of the incident wave exceeds a Brillouin threshold dependent on the adjustable parameters including said size and said sequence parameter, the power of the diffracted wave constituting a returned power;
a receiver (16) receiving said incident wave at the output of said line fiber to recover the data to be transmitted which was possibly carried by said input signal;
a measuring member (18) for measuring said returned power; and
an adjustment member (20);
the adjustment member controlling:
said laser source (8, 10) with respect to the power of said incident wave;
said pulse generator (12) with respect to said size; and
said sequence generator (14) with respect to said sequence parameter;
the adjustment member being connected to said measurement member (18) in order to be informed of the values of said returned power, said adjustment member controlling said generators and source so as to perform adjustment operations during adjustment periods and to perform transmission operations during periods of transmission outside of the adjustment periods, the adjustment member performing the adjustment operations by giving various values to said power of the incident wave so as to give various values to said returned power and by defining an optimal value for said size as a function of said various values of the returned power, the adjustment member performing the transmission operations by causing said data to be transmitted to be carried by said input signal while giving said size its said optimal value and while giving a predetermined value to said power of the incident wave.
